# EUROPÄISCHE PATENTANMELDUNG

(11) **EP 0 764 956 A2**
(43) Veröffentlichungstag der Anmeldung: **26.03.1997**
(21) Anmeldenummer: 96113007.7
(22) Anmeldetag: 13.08.1996
(51) Int. Cl.: H01F 27/06

(54) **Elektrisches Bauelement für den Einbau in doppelt mit Leiterbahnen kaschierten Leiterplatten**

(30) Priorität: 22.09.1995 DE 19535308
(71) Anmelder: SIEMENS MATSUSHITA COMPONENTS GmbH & CO KG, 81541 München (DE)
(72) Erfinder: Meindl, Gerhard, 82239 Alling (DE)
(74) Vertreter: Fuchs, Franz-Josef, Dr.-Ing.

(57) **Zusammenfassung**

Auf eine mit Leiterbahnen auf einer Leiterplatte in Kontakt tretende Fläche eines elektrischen Bauelementes ist eine Isolationsschicht (7) aufgebracht.

## Beschreibung

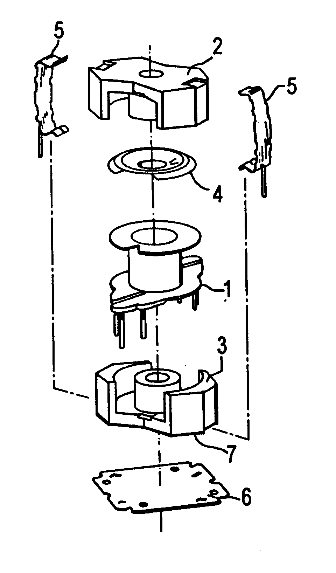

Die vorliegende Erfindung betrifft ein elektrisches Bauelement für den Einbau in doppelt mit Leiterbahnen kaschierten Leiterplatten nach dem Oberbegriff des Patentanspruchs 1. Bei Verwendung von doppelt mit Leiterplatten kaschierten Leiterplatten muß ein aufliegendes elektrisches Bauelement gegen die Leiterbahnen der Leiterplatte isoliert werde. Beispielsweise bei einem aus dem Datenbuch 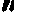 Ferrite und Zubehör" der Siemens Matsushita Components GmbH und Co. KG, Ausgabe 1964, Seite 215 bekannten induktiven Bauelement sind zudem vorgenannten Zweck Isolationsmittel vorgesehen, die anhand der einzigen Figur der Zeichnung erläutert werden. Die Figur der Zeichnung zeigt die wesentlichen Teile induktiven Bauelementes anhand der Figur werden zunächst die bekannten Elemente eines derartigen induktiven Bauelementes beschrieben. Das Bauelement besitzt einen Spulenkörper 1 sowie zwei Magnetkernhälften 2, 3, welche auf den Spulenkörper 1 aufgesetzt und mittels Klammern 5 auf dem Spulenkörper gehalten werden. Eine vom Spulenkörper 1 getragene Wicklung des induktiven Bauelementes ist in der Figur aus Übersichtlichkeitsgründen nicht dargestellt. Zwischen den Spulenkörper 1 und die obere Kernhälfte 2 ist eine erste Isolierscheibe 4 eingefügt. Eine zweite Isolierscheibe 6 wird auf die Unterseite der unteren Kernhälfte 3 aufgesetzt. Wird das insoweit beschriebene induktive Bauelement auf eine Seite einer nicht dargestellten beidseitig mit Leiterbahnen kaschierten Leiterplatte mit der Unterseite der unteren Kernhälfte 3 aufgesetzt, so isoliert die zweite Isolierscheibe 6 das induktive Bauelement gegen die Leiterbahnen auf der Leiterplatte.

Zwar wird durch die zweite Isolierscheibe 6 eine zufriedenstellende Isolation des induktiven Bauelementes gegen die Leiterbahnen auf der Leiterplatte erreicht. In der Fertigungstechnik für induktive Bauelemente führt jedoch die zweite Isolierscheibe 6 zu einem erhöhten Montageaufwand und damit zu höheren Montagekosten.

Der vorliegenden Erfindung liegt die Aufgabe zugrunde, ein elektrisches Bauelement der in Rede stehenden Art mit Isolationsmittel anzugeben, durch die der Montageaufwand und die Montagekosten geringer gehalten werden können.

Diese Aufgabe wird bei einem elektrischen Bauelement der eingangsgenannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird nachfolgend anhand der bereits oben weitgehend erläuterten einzigen Figur der Zeichnung näher erläutert.

Anstelle der zweiten Isolierscheibe 6 ist auf die mit Leiterbahnen auf einer Leiterplatte in Kontakt gelangende Fläche - das ist die Unterseite der Kernhälfte 3 - direkt eine Isolationsschicht 7 aufgebracht. Diese Isolationsschicht 7 kann beispielsweise als Isolationslackschicht oder als aufgedampfte Isolationsschicht ausgebildet sein.

Durch diese erfindungsgemäß vorgesehene Isolationsschicht 7 entfallen ein zusätzlicher Montageaufwand und damit zusätzliche Montagekosten, wie sie durch ein gesondert vorgesehenes Isolationselement in Form der Isolierscheibe 6 entstehen.

## Patentansprüche

1. Elektrisches Bauelement für den Einbau in doppelt mit Leiterbahnen kaschierten Leiterplatten mit Mitteln (7) zur Isolation des Bauelementes gegen die Leiterbahnen,
**dadurch gekennzeichnet**,
daß die Mittel (7) als direkt auf eine mit den Leiterbahnen auf der Leiterplatte in Kontakt gelangende Fläche aufgebrachte Isolationsschicht ausgebildet sind.

2. Elektrisches Bauelement nach Anspruch 1,
**dadurch gekennzeichnet**,
daß die Isolationsschicht (7) eine Isolationslackschicht ist.

3. Elektrisches Bauelement nach Anspruch 1,
**dadurch gekennzeichnet**,
daß die Isolationsschicht (7) eine aufgedampfte Schicht ist.

4. Elektrisches Bauelement nach einem der Ansprüche 1 bis 3 in Form eines induktiven Bauelementes,
**dadurch gekennzeichnet**,
daß die Isolationsschicht (7) auf die mit den Leiterbahnen auf der Leiterplatte in Kontakt gelangende Unterseite eines Magnetkerns (2, 3) aufgebracht ist.
